(19) Europäisches Patentamt
European Patent Office
Office européen des brevets

(11) **EP 2 725 608 A2**

(12) **EUROPEAN PATENT APPLICATION**

(43) Date of publication:
**30.04.2014 Bulletin 2014/18**

(51) Int Cl.:
**H01L 23/053** (2006.01)

(21) Application number: **13190259.5**

(22) Date of filing: **25.10.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **29.10.2012 JP 2012237993**

(71) Applicant: **NITTO DENKO CORPORATION**
**Ibaraki-shi,**
**Osaka 567-8680 (JP)**

(72) Inventors:
• **Tsukahara, Daisuke**
**Osaka 567-8680 (JP)**
• **Ebe, Yuki**
**Osaka 567-8680 (JP)**

(74) Representative: **HOFFMANN EITLE**
**Patent- und Rechtsanwälte**
**Arabellastrasse 4**
**81925 München (DE)**

(54) **Encapsulating sheet container**

(57) A encapsulating sheet container for storing a encapsulating sheet including a substrate and a encapsulating layer stacked on the substrate includes a tray provided with a receiving region receiving the substrate and a cover superposed on the tray not to be in contact with the encapsulating layer and to be at an interval from the receiving region.

Fig1

**Description**

**BACKGROUND OF THE INVENTION**

**Field of the Invention**

The present invention relates to a encapsulating sheet container, and more particularly, it relates to a encapsulating sheet container storing a encapsulating sheet.

**Description of Related Art**

A technique of encapsulating an electronic element or the like with a encapsulating sheet for constituting an electronic device is known in general.

A encapsulating sheet including a resin film and a release sheet temporarily tacked to the surface of the resin film is known as such a encapsulating sheet (refer to Japanese Unexamined Patent Publication No. 2009-141020, for example).

In such a encapsulating sheet, the release sheet protects the surface of the resin film in shipping.

In use of the encapsulating sheet, the resin film is exposed by peeling off the release sheet and stuck to an electronic element or the like.

**SUMMARY OF THE INVENTION**

When tacky resin is used as the material for the resin film of the aforementioned encapsulating sheet disclosed in Japanese Unexamined Patent Publication No. 2009-141020, however, the release sheet cannot be temporarily tacked to the resin film in order to protect the same.

If the surface of the resin film is not protected, the encapsulating sheet cannot satisfy its function due to contact with dust in the air or another member.

Accordingly, an object of the present invention is to provide a encapsulating sheet container capable of protecting a encapsulating layer.

The encapsulating sheet container according to the present invention is a encapsulating sheet container for storing a encapsulating sheet including a substrate and a encapsulating layer stacked on the substrate. The encapsulating sheet container includes a tray provided with a receiving region receiving the substrate and a cover superposed on the tray not to be in contact with the encapsulating layer and to be at an interval from the receiving region.

In such a encapsulating sheet container, the substrate of the encapsulating sheet is placed on the receiving region of the tray, and the cover is thereafter superposed on the tray, not to come into contact with the encapsulating layer of the encapsulating sheet and to be at an interval from the receiving region.

Therefore, the encapsulating sheet container can store the encapsulating sheet without bringing the encapsulating layer and the cover into contact with each other.

Consequently, the encapsulating sheet container can protect the encapsulating layer of the encapsulating sheet.

Preferably in the encapsulating sheet container according to the present invention, the tray and the cover include a tray-side fixing portion and a cover-side fixing portion for fixing the substrate by partially holding the substrate therebetween.

In such a encapsulating sheet container, the cover is so superposed on the tray from above that the tray-side fixing portion and the cover-side fixing portion can fix the substrate by partially holding the same therebetween, thereby fixing the encapsulating sheet.

Therefore, the tray-side fixing portion and the cover-side fixing portion can suppress relative displacement of the encapsulating sheet with respect to the encapsulating sheet container.

Preferably in the encapsulating sheet container according to the present invention, the receiving region of the tray is provided with a projection protruding upward to be inserted into a through-hole of the substrate.

In such a encapsulating sheet container, the encapsulating sheet is so placed on the receiving region of the tray that the projection is inserted into the through-hole of the substrate, whereby the position of the encapsulating sheet with respect to the tray is fixed.

Therefore, the projection can further suppress relative displacement of the encapsulating sheet with respect to the tray.

Preferably in the encapsulating sheet container according to the present invention, a plurality of receiving regions are provided to be adjacent to each other, and the tray includes a separating portion separating the receiving regions from each other.

In such a encapsulating sheet container, the separating portion is provided in the encapsulating sheet container, whereby encapsulating sheets placed on the respective receiving regions can be prevented from coming into contact with each other.

Therefore, the encapsulating sheet container can store a plurality of encapsulating sheets, while the same can reliably protect the encapsulating layers of the encapsulating sheets.

Preferably in the encapsulating sheet container according to the present invention, a pair of through-holes passing through the substrate in the thickness direction are formed on both end portions of the substrate, a plurality of receiving regions are provided to be adjacent to each other, the tray includes a pair of projections protruding upward to be inserted into the through-holes and a separating portion separating the receiving regions from each other. In this case, the length L0 between the pair of through-holes, the length L1 between the pair of projections and the protrusion length L2 of the separating portion satisfy the following formula:

$$(L2) > [(L0)/2] \times [Tan(Acos(L1)/(L0))]$$

In such a encapsulating sheet container, the substrate can be prevented from getting over the separating portion when the height of the separating portion satisfies the above formula, even if the length L0 between the pair of through-holes and the length L1 between the pair of projections are different from each other and the substrate is warped to separate from the receiving region.

Therefore, the encapsulating sheets placed on the respective receiving regions can be reliably prevented from coming into contact with each other.

Consequently, the encapsulating sheet container can reliably protect the encapsulating layers of the encapsulating sheets.

Preferably in the encapsulating sheet container according to the present invention, the separating portion is configured to be contactable with the cover in a state where the cover is superposed on the tray.

In such a encapsulating sheet container, no clearance is formed between adjacent receiving regions when the separating portion and the cover are in contact with each other.

Therefore, the encapsulating sheet can be reliably prevented from getting over the separating portion and moving toward an adjacent receiving region.

Preferably in the encapsulating sheet container according to the present invention, the cover includes a support portion for supporting another tray when the other tray is superposed thereon.

In such a encapsulating sheet container, not only the cover is superposed on the tray, but another tray can be superposed on the cover by arranging the other tray on the support portion of the cover.

Therefore, a plurality of encapsulating sheet containers can be superposed on each other, thereby saving the space and improving transportation efficiency.

## BRIEF DESCRIPTION OF THE DRAWINGS

FIG. 1 is an exploded perspective view of a encapsulating sheet container according to an embodiment of the present invention and a encapsulating sheet.

FIG. 2 is a plan view of the encapsulating sheet container shown in FIG. 1.

FIG. 3 is a plan view of a cover shown in FIG. 1.

FIG. 4 is a plan view of a tray shown in FIG. 1.

FIG. 5 is a sectional view of the encapsulating sheet container taken along a line A-A in FIG. 2, showing a state where the tray and the cover are not yet assembled with each other.

FIG. 6 is another sectional view of the encapsulating sheet container taken along the line A-A in FIG. 2, showing a state where the tray and the cover are assembled with each other.

FIG. 7 is a plan sectional view of the tray and the encapsulating sheet shown in FIG. 1.

FIG. 8 is a perspective view of a stacked state of encapsulating sheet containers shown in FIG. 1 as viewed from the upper right side.

FIG. 9 is a plan sectional view of the stacked encapsulating sheet containers shown in FIG. 8.

**DETAILED DESCRIPTION OF THE EMBODIMENTS**

1. Structure of Encapsulating Sheet Container

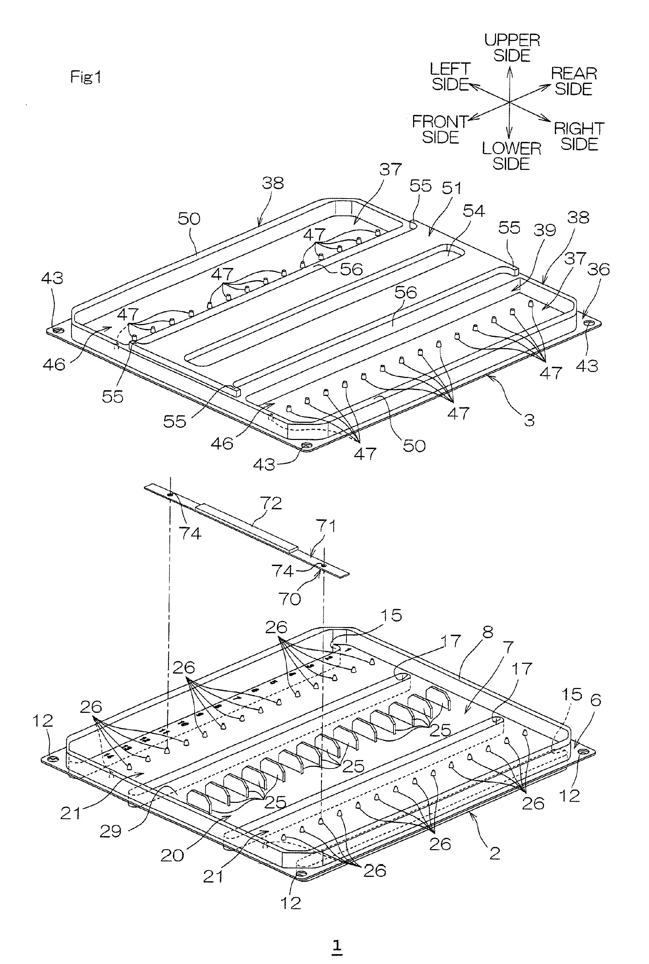

A encapsulating sheet container 1 according to an embodiment of the present invention, employed for storing a encapsulating sheet 70 (described later), includes a tray 2 and a cover 3, as shown in FIG. 1.

The encapsulating sheet container 1 is described with reference to directions in a case where the same is horizontally placed. More specifically, the encapsulating sheet container 1 is described with reference to the directions of arrows appearing in the drawings.

(1) Tray

The tray 2, made of resin such as polyester resin such as polyethylene terephthalate (PET) or polyolefin resin such as polyethylene (PE), for example, is provided in the form of a thin plate having a constant thickness (0.3 to 1.0 mm, for example). The tray 2 integrally includes a tray flange portion 6, a tray plate portion 7 and a tray frame portion 8.

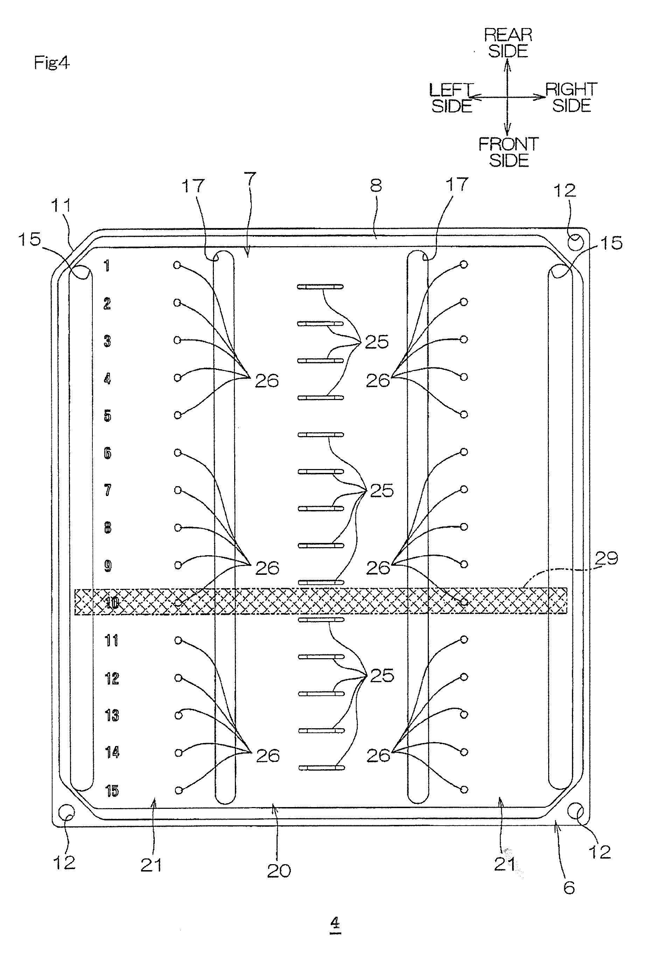

The tray flange portion 6 is provided in the form of a generally rectangular frame in plan view on a peripheral edge portion of the tray 2, as shown in FIG. 4. A tray notch 11 and a plurality of (three) tray through-holes 12 are formed on the tray flange portion 6.

The tray notch 11 is formed to notch the rear left corner among four corners of the tray flange portion 6.

The tray through-holes 12 are formed to pass through the remaining three corners, other than the rear left one, of the tray flange portion 6 generally circularly in plan view.

The tray plate portion 7, forming an inner portion of the tray 2, is provided in the form of a generally rectangular flat plate in plan view to be arranged on the tray 2 inwardly beyond an inner peripheral edge of the tray flange portion 6.

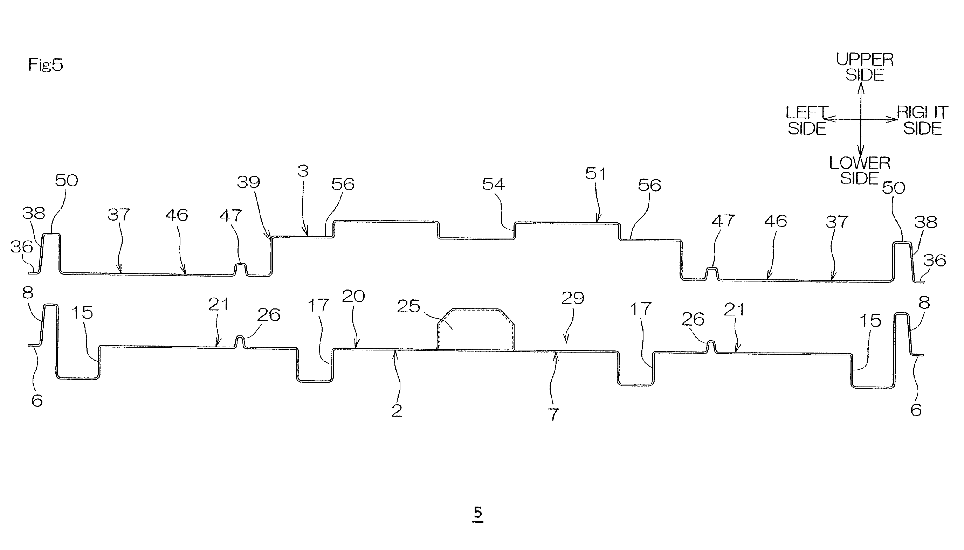

The tray frame portion 8 is provided in the form of a frame, generally rectangular in plan view, coupling the inner peripheral edge of the tray flange portion 6 and an outer peripheral edge of the tray plate portion 7 with each other (see FIG. 4) and projecting upward, as shown in FIGS. 1 and 5. The tray frame portion 8 is so formed that an outer portion thereof slightly inclines toward the inner side of the tray 2 upward, and provided to have a generally trapezoidal section narrowing upward.

(1-1) Tray Plate Portion

The tray plate portion 7 includes a pair of first supported recesses 15 and a pair of second supported recesses 17. Further, a pair of engaging projection forming portions 21 (examples of the tray-side fixing portion) and a partitioning projection forming portion 20 are provided on the tray plate portion 7.

The pair of first supported recesses 15 are formed on both end portions of the tray plate portion 7 in the left-and-right direction as depressions concaved downward from the tray plate portion 7 over the whole area in the front-and-rear direction. Outer side edges of the pair of first supported recesses 15 in the left-and-right direction are flush with inner side edges of both side portions of the tray frame portion 8 in the left-and-right direction.

The pair of second supported recesses 17 are arranged on the tray plate portion 7 at intervals from inner side edges of the pair of first supported recesses 15 in the left-and-right direction toward inner sides in the left-and-right direction, and formed as depressions concaved downward from the tray plate portion 7 over the whole area in the front-and-rear direction. The length of the second supported recesses 17 in the upper-and-lower direction is generally identical to that of the first supported recesses 15.

The pair of engaging projection forming portions 21 of the tray plate portion 7 are provided generally in the form of rectangles in plan view to be longitudinal in the front-and-rear direction, as portions located between the inner side edges of the pair of first supported recesses 15 in the left-and-right direction and outer side edges of the pair of second supported recesses 17 in the left-and-right direction. Arabic numerals 1 to 15 are stamped on the left end portion of the left engaging projection forming portion 21 at regular intervals from a rear end portion toward a front end portion. A plurality of (15) engaging projections 26 (examples of the projection) are provided on each of the pair of engaging projection forming portions 21. In other words, the engaging projections 26 are provided in a plurality of pairs (15 pairs).

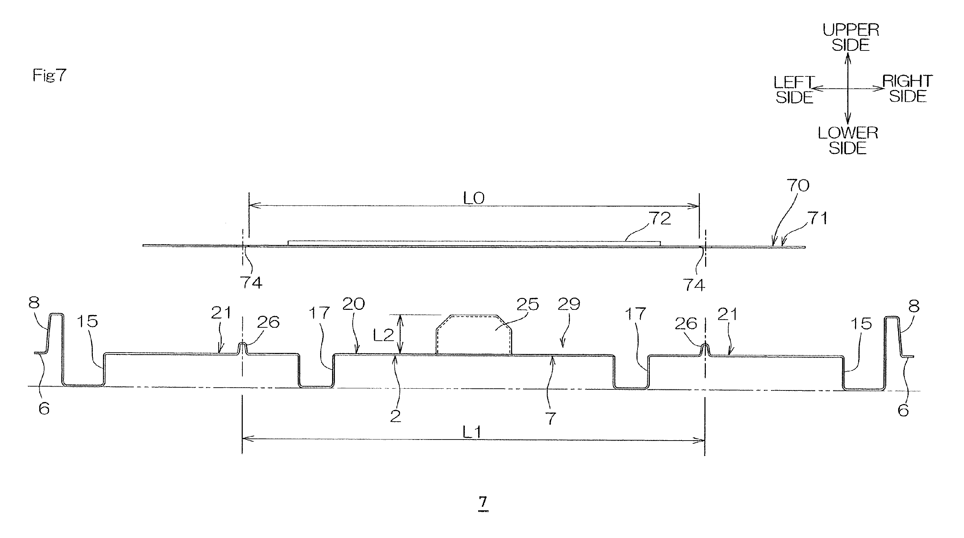

The plurality of engaging projections 26 are arranged at regular intervals in the front-and-rear direction at generally central portions of the engaging projection forming portions 21 in the left-and-right direction. The engaging projections 26 are provided generally in the form of cones protruding upward from the engaging projection forming portions 21. The distance between each pair of engaging projections 26 is referred to as an inter-engaging-projection distance L1 (see FIG. 7).

The partitioning projection forming portion 20 is provided on the tray plate portion 7 generally in the form of a rectangle in plan view to be longitudinal in the front-and-rear direction, as a portion between the pair of second supported recesses 17. The partitioning projection forming portion 20 includes a plurality of (14) partitioning projections 25 (examples of the partitioning portion).

The plurality of partitioning projections 25 are arranged on a generally central portion of the partitioning projection forming portion 20 in the left-and-right direction, and parallelly arranged at regular intervals in the front-and-rear direction to be generally at the centers between adjacent pairs of the engaging projections 26 in the front-and-rear direction. The partitioning projections 25 are generally provided in the form of rectangles in side elevational view, longitudinal in the left-and-right direction, protruding upward from the partitioning projection forming portion 20. Both end portions of upper portions of the partitioning projections 25 in the left-and-right direction incline toward inner sides in the left-and-right direction upward. The length (referred to as a partitioning projection height L2 (see FIG. 7)) of the partitioning projections 25 in the upper-and-lower direction is generally identical to that of the tray frame portion 8.

In the tray 2, spaces surrounded by adjacent partitioning projections 25 and both side portions of the tray frame portion 8 in the left-and-right direction are defined as receiving regions 29 (see a halftone region in FIG. 4). A space surrounded by the partitioning projection 25 on the front end portion as well as both side portions in the left-and-right direction and the front side portion of the tray frame portion 8 is defined as the receiving region 29 on the front end portion, while a space surrounded by the partitioning projection 25 on the rear end portion as well as both side portions in the left-and-right direction and the rear side portion of the tray frame portion 8 is defined as the receiving region 29 on the rear end portion. In other words, the receiving regions 29 are provided on 15 portions correspondingly to the Arabic numerals 1 to 15 on the left engaging projection forming portion 21.

(2) Cover

The cover 3, made of the same resin as the tray 2, is provided in the form of a thin plate having a constant thickness (0.3 to 1.0 mm, for example), as shown in FIG. 1. The cover 3 integrally includes a cover flange portion 36, a pair of cover plate portions 37, a cover frame portion 38 and a cover frame coupling portion 39.

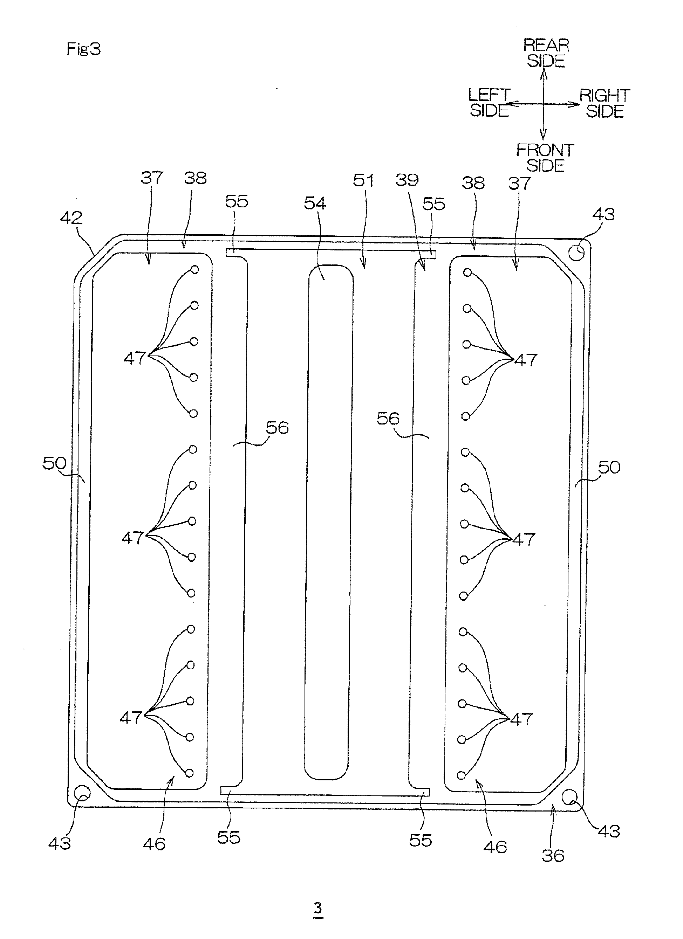

The cover flange portion 36 is provided on a peripheral edge portion of the cover 3 in the form of a generally rectangular frame in plan view, as shown in FIG. 3. The cover flange portion 36 is provided with a cover notch 42 and a plurality of (three) cover through-holes 43.

The cover notch 42 is formed to notch the rear left corner among four corners of the cover flange portion 36.

The cover through-holes 43 are formed to pass through the remaining three corners, other than the rear left one, of the cover flange portion 36 generally circularly in plan view.

In other words, the cover flange portion 36 is formed to be generally identical in shape to the tray flange portion 6 of the tray 2.

The cover plate portions 37, forming both side portions of inner side portions of the cover 3 in the left-and-right direction, are arranged in a pair at an interval from each other in the left-and-right direction on the inner side of the cover 3 beyond an inner peripheral edge of the cover flange portion 36. The length between inner side edges of the pair of cover plate portions 37 in the left-and-right direction is larger than the distance between outer side edges of the pair of second supported recesses 17 of the tray 2 in the left-and-right direction and smaller than the distance between the pair of engaging projections 26, as shown in FIG. 5. The cover plate portions 37 are provided in the form of flat plates generally rectangular in plan view.

The cover frame portion 38, coupling the inner peripheral edge of the cover flange portion 36 and the outer peripheral edges of the pair of cover plate portions 37 (more specifically, both end edges in the front-and-rear direction and outer end edges in the left-and-right direction of the pair of cover plate portions 37) with each other, is provided in the form of a generally rectangular frame in plan view to protrude upward, as shown in FIG. 1. Outer side portions of the cover frame portion 38 are formed to slightly incline toward the inner side of the tray 2 upward to have generally trapezoidal sections narrowing upward, as shown in FIG. 5. The cover frame portion 38 is so formed that the width thereof (the length in a direction orthogonal to the extensional direction of the cover frame portion 38) is slightly larger than the width of the tray frame portion 8 of the tray 2 (the length in a direction orthogonal to the extensional direction of the tray frame portion 8).

The cover frame coupling portion 39 is formed between the pair of cover plate portions 38 to generally rectangularly protrude upward from the cover plate portions 37, as shown in FIGS. 1 and 5. The length of the cover frame coupling portion 39 in the upper-and-lower direction is generally identical to that of the cover frame portion 38, a front end portion thereof is continuous with that of the cover frame portion 38, and a rear side portion thereof is continuous with that of the cover frame portion 38.

(2-1) Cover Plate Portion

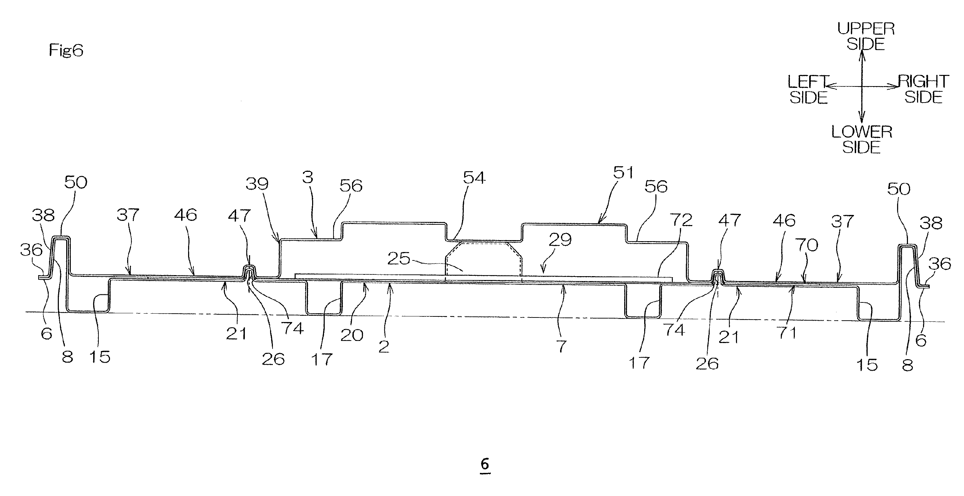

In the cover plate portions 37, portions overlapping the engaging projection forming portions 21 when projected in the upper-and-lower direction in a state where the tray 2 and the cover 3 are assembled with each other are defined as engaged projection forming portions 46 (examples of the cover-side fixing portion), as shown in FIG. 6.

A plurality of (15) engaged projections 47 are formed on each of the pair of engaged projection forming portions 46. In other words, the engaged projections 47 are provided in a plurality of pairs (15 pairs).

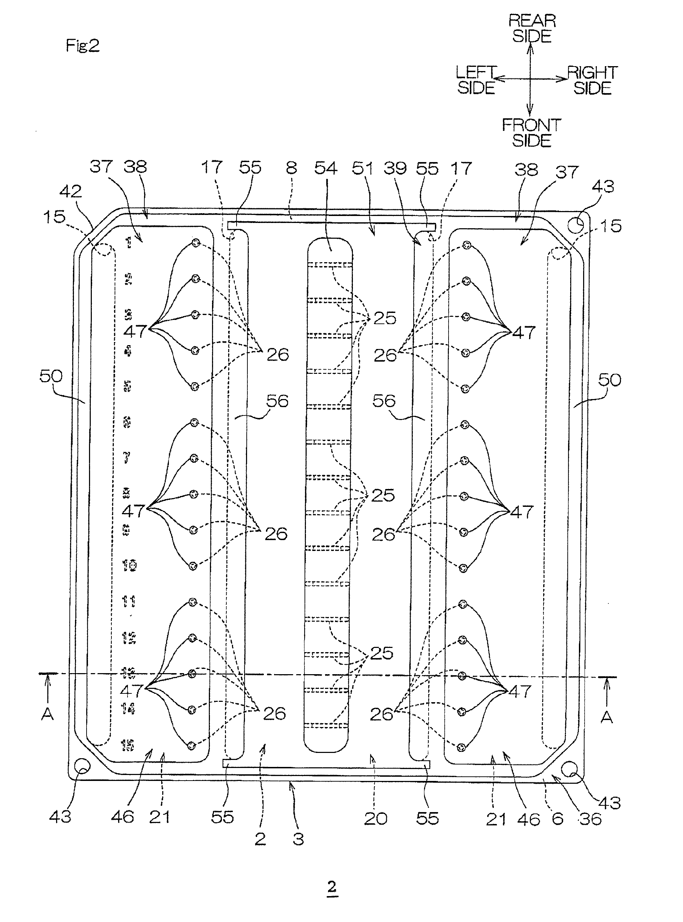

The plurality of engaged projections 47 are arranged at regular intervals in the front-and-rear direction on inner side portions of the engaged projection forming portions 46 in the left-and-right direction to overlap the plurality of engaging projections 26 of the tray 2 when projected in the upper-and-lower direction, as shown in FIG. 2. The engaged projections 47 are provided generally in the form of truncated cones protruding upward from the engaged projection forming portions 46, as shown in FIGS. 1 and 5. The inner shapes of the engaged projections 47 are generally identical to (slightly larger than) the outer shapes of the engaging projections 26.

(2-2) Cover Frame Coupling Portion

A cover swelling portion 51 is integrally formed on the cover frame coupling portion 39.

The cover swelling portion 51 is formed on a generally central portion of the cover frame coupling portion 39 in the left-and-right direction, as shown in FIG. 3. The cover swelling portion 51 is provided generally in the form of a rectangle in plan view to slightly protrude upward from the cover frame coupling portion 39, as shown in FIGS. 1 and 5. The length of the cover swelling portion 51 in the left-and-right direction is generally identical to (slightly smaller than) the length between inner side edges of the pair of second supported recesses 17 of the tray 2 in the left-and-right direction. The cover swelling portion 51 includes a contacted recess 54 and a plurality of (four) corner portions 55.

The contacted recess 54 is arranged on a generally central portion of the cover swelling portion 51 in the front-and-rear direction slightly separating from both end edges of the cover swelling portion 51 in the front-and-rear direction toward the inner side. The contracted recess 54 is formed as a depression concaved downward from the cover swelling portion 51. The contacted recess 54 is so formed that the distance from the lower surface thereof to those of the cover plate portions 37 is generally identical to the partitioning projection height L2.

The plurality of corner portions 55 are formed to swell out from four corners of the cover swelling portion 51 outward in the left-and-right direction, as shown in FIG. 3. The plurality of corner portions 55 are so formed that the distance between outer end portions thereof in the left-and-right direction is shorter than the length of the cover frame coupling portion 39 in the left-and-right direction and the distance between inner side edges thereof in the front-and-rear direction is generally identical to (slightly larger than) the length of the second supported recesses 17 of the tray 2 in the front-and-rear direction.

The upper surfaces of both side portions of the cover frame portion 38 in the left-and-right direction are defined as first support portions 50 (examples of the support portion), and portions surrounded by both outer side surfaces of the cover swelling portion 51 in the left-and-right direction, inner side surfaces of the corner portions 55 in the front-and-rear direction and the upper surface of the cover frame coupling portion 39 are defined as second support portions 56 (examples of the support portion).

2. Structure of Encapsulating Sheet

The encapsulating sheet 70 includes a substrate 71 and a encapsulating layer 72, as shown in FIG. 1.

The substrate 71 is provided in the form of a thin plate, generally rectangular in plan view and longitudinal in the left-and-right direction, having a constant thickness (0.02 to 1.00 mm, for example) in the upper-and-lower direction. The length of the substrate 71 in the left-and-right direction is smaller than the distance between inner side edges of the pair of first supported recesses 15 of the tray 2 in the left-and-right direction. The substrate 71 is provided with a pair of projection receiving holes 74 (examples of the through-hole).

The pair of projection receiving holes 74 are formed to pass through both end portions of the substrate 71 in the left-and-right direction generally circularly in plan view. The distance between the pair of projection receiving holes 74 is referred to as an inter-projection-receiving-hole distance L0.

The encapsulating layer 72 is made of pressure sensitive resin and provided in the form of a thin plate, generally rectangular in plan view, stacked on a generally central portion of the substrate 71 in the left-and-right direction. The encapsulating layer 72 is so formed that the length thereof in the left-and-right direction is smaller than that of the cover frame coupling portion 39, to expose the pair of projection receiving holes 74.

3. Dimensions of Encapsulating Sheet Container and Encapsulating Sheet

In relation to the encapsulating sheet container 1 and the encapsulating sheet 70, it is assumed that the relation between the inter-projection-receiving-hole distance L0, the inter-engaging-projection distance L1 and the partitioning projection height L2 satisfies the following formula:

$$(L2) > [(L0)/2] \times [Tan(Acos(L1)/(L0))]$$

4. Assembling of Encapsulating Sheet Container

The aforementioned tray 2 and the cover 3 are so assembled with each other that the encapsulating sheet container 1 stores the aforementioned encapsulating sheet 70.

In order to assemble the encapsulating sheet container 1, the aforementioned tray 2 and the encapsulating sheet 70 are first prepared, and the encapsulating sheet 70 is placed on the tray 2.

In order to place the encapsulating sheet 70 on the tray 2, the lower surfaces of the pair of second supported recesses 17 and those of the pair of first supported recesses 15 are grounded, and the tray 2 is horizontally placed, as shown in FIG. 7.

Then, the encapsulating sheet 70 is set on the tray 2 from above so that the left-and-right pair of engaging projections 26 are inserted into the left-and-right pair of projection receiving holes 74 respectively. Thus, the encapsulating sheet 70 is placed on the corresponding receiving region 29 of the tray 2.

The receiving regions 29 are formed on 15 portions, whereby 15 encapsulating sheets 70 can be placed on one encapsulating sheet container 1 at a maximum.

Then, the cover 3 is assembled with the tray 2 receiving the encapsulating sheet 70, as shown in FIG. 6.

In order to assemble the cover 3 with the tray 2 receiving the encapsulating sheet 70, the cover 3 is assembled with the tray 2 from above.

More specifically, the cover 3 is superposed on the tray 2 from above, so that the tray frame portion 8 of the tray 2 and the cover frame portion 38 of the cover 3 coincide with each other while the plurality of pairs of engaging projections 26 of the tray 2 and the plurality of pairs of engaged projections 47 of the cover 3 coincide with each other.

Thus, the engaging projection forming portions 21 of the tray 2 and the engaged projection forming portions 46 of the cover 3 hold both end portions of the substrate 71 of the encapsulating sheet 70 in the left-and-right direction therebetween.

In other words, the engaging projections 26 of the tray 2 restrict movement of the encapsulating sheet 70 in the front-and-rear and left-and-right directions, while the engaging projection forming portions 21 of the tray 2 and the engaged projection forming portions 46 of the cover 3 hold the encapsulating sheet 70 therebetween thereby restricting movement of the encapsulating sheet 70 in the upper-and-lower direction.

At this time, the upper surfaces of the partitioning projections 25 of the tray 2 and the lower surface of the contacted recess 54 of the cover 3 are brought into contact with each other.

Thus, the cover 3 is completely assembled with the tray 2 receiving the encapsulating sheet 70.

5. Transportation State of Encapsulating Sheet Container

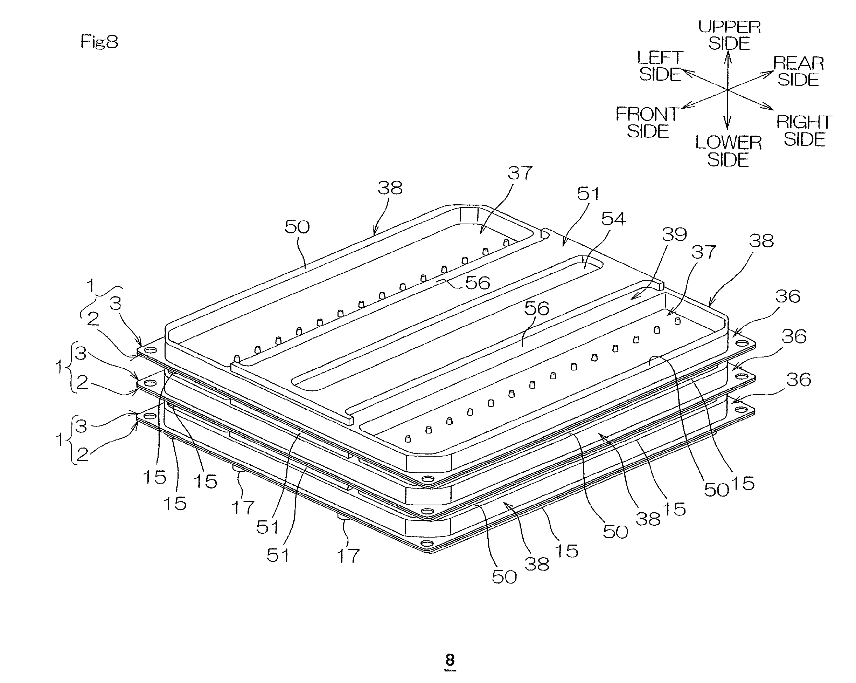

In shipping and transportation, a plurality of encapsulating sheet containers 1 are superposed on each other to be shipped and transported, as shown in FIG. 8.

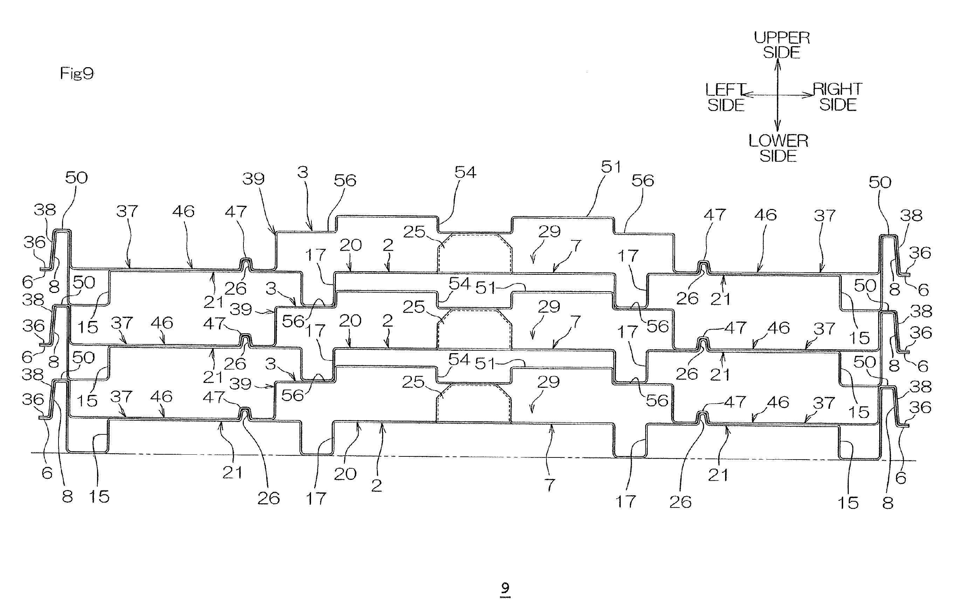

In order to superpose such encapsulating sheet containers 1 on each other, an upper encapsulating sheet container 1 is assembled to a lower encapsulating sheet container 1 from above, as shown in FIG. 9.

More specifically, the upper encapsulating sheet container 1 is superposed on the lower encapsulating sheet container 1 so that outer side edges of the lower surfaces of the first supported recesses 15 of the tray 2 of the upper encapsulating sheet container 1 in the left-and-right direction and the first support portions 50 of the cover frame portion 38 of the cover 3 of the lower encapsulating sheet container 1 coincide with each other while the second supported recesses 17 of the tray 2 of the upper encapsulating sheet container 1 and the second support portions 56 of the cover 3 of the lower encapsulating sheet container 1 coincide with each other.

At this time, inner side surfaces of the second supported recesses 17 of the tray 2 of the upper encapsulating sheet container 2 in the left-and-right direction are brought into contact with outer side surfaces of the cover swelling portion 51 of the cover 3 of the lower encapsulating sheet container 1 in the left-and-right direction and outer side surfaces thereof in the front-and-rear direction are brought into contact with inner side surfaces of the plurality of corner portions 55 of the cover 3 of the lower encapsulating sheet container 1 in the front-and-rear direction, thereby restricting relative displacement of the upper and lower encapsulating sheet containers 1 in the front-and-rear and left-and-right directions.

Thus, the cover 3 of the lower encapsulating sheet container 1 supports the tray 2 of the upper encapsulating sheet container 1, and the lower encapsulating sheet container 1 supports the upper encapsulating sheet container 1. More encapsulating sheet containers 1 can be superposed in a similar manner.

6. Functions/Effects

In the encapsulating sheet container 1, the substrate 71 of the encapsulating sheet 70 is placed on the corresponding receiving region 29 of the tray 2, and the cover 3 is thereafter superposed on the tray 2 at an interval from the receiving region 29 not to come into contact with the encapsulating layer 72 of the encapsulating sheet 70, as shown in FIG. 6.

Therefore, the encapsulating sheet container 1 can store the encapsulating sheet 70 without brining the encapsulating layer 72 and the cover 3 into contact with each other.

Consequently, the encapsulating sheet container 1 can protect the encapsulating layer 72 of the encapsulating sheet 70.

In the encapsulating sheet container 1, further, the cover 3 is superposed on the tray 2 from above, whereby the engaging projection forming portions 21 and the engaged projection forming portions 46 can fix both end portions of the substrate 71 in the left-and-right direction by holding the same therebetween, thereby fixing the encapsulating sheet 70.

Therefore, the engaging projection forming portions 21 and the engaged projection forming portions 46 can restrict relative displacement of the encapsulating sheet 70 from the encapsulating sheet container 1.

In the encapsulating sheet container 1, the encapsulating sheet 70 is so placed on the corresponding receiving region 29 of the tray 2 that the engaging projections 26 are inserted into the projection receiving holes 74 of the substrate 71, whereby the position of the encapsulating sheet 70 with respect to the tray 2 is fixed.

Therefore, the engaging projections 26 can further restrict relative displacement of the encapsulating sheet 70 with respect to the tray 2.

In the encapsulating sheet container 1, the partitioning projections 25 are provided in the encapsulating sheet container 1 as shown in FIG. 1, whereby the encapsulating sheets 70 placed on the respective receiving regions 29 can be prevented from coming into contact with each other.

Therefore, the encapsulating sheet container 1 can store a plurality of encapsulating sheets 70, while the same can reliably protect the encapsulating layers 72 thereof.

In the encapsulating sheet container 1, the partitioning projection height L2 so satisfies the above formula that the substrate 71 can be prevented from getting over the partitioning projections 25, even if the lengths of the inter-projection-receiving-hole distance L0 and the inter-engaging-projection distance L1 are different from each other as shown in FIG. 7 and the substrate 71 is warped to separate from the corresponding receiving region 29.

Therefore, the encapsulating sheets 70 placed on the respective receiving regions 29 can be reliably prevented from coming into contact with each other.

Consequently, the encapsulating sheet container 1 can reliably protect the encapsulating layers 72 of the encapsulating sheets 70.

In the encapsulating sheet container 1, the partitioning projections 25 and the cover 3 are in contact with each other as shown in FIG. 6, whereby no clearance is formed between the adjacent receiving regions 29.

Therefore, the encapsulating sheet 70 can be reliably prevented from getting over the partitioning projections 25 and moving toward the adjacent receiving region 29.

In the encapsulating sheet container 1, not only the cover 3 is superposed on the tray 2, but another tray 2 can be superposed on the cover 3 by arranging the first supported recesses 15 of the other tray 2 on the first support portions 50 of the cover 3 and arranging the second supported recesses 17 of the other tray 2 on the second support portions 56 of the cover 3, as shown in FIGS. 8 and 9.

Therefore, a plurality of encapsulating sheet containers 1 can be superposed on each other, thereby saving the space and improving transportation efficiency.

**Claims**

1. A encapsulating sheet container for storing a encapsulating sheet including a substrate and a encapsulating layer stacked on the substrate, comprising:

   a tray provided with a receiving region receiving the substrate; and
   a cover superposed on the tray not to be in contact with the encapsulating layer and to be at an interval from the receiving region.

2. The encapsulating sheet container according to Claim 1, wherein
   the tray and the cover include a tray-side fixing portion and a cover-side fixing portion for fixing the substrate by partially holding the substrate therebetween.

3. The encapsulating sheet container according to Claim 1 or 2, wherein
   the receiving region of the tray is provided with a projection protruding upward to be inserted into a through-hole of the substrate.

4. The encapsulating sheet container according to Claim 1, 2 or 3, wherein
   a plurality of the receiving regions are provided to be adjacent to each other, and
   the tray includes a separating portion separating the receiving regions from each other.

5. The encapsulating sheet container according to any one of the preceding Claims 1 to 4, wherein
   a pair of through-holes passing through the substrate in the thickness direction are formed on both end portions of the substrate,
   a plurality of the receiving regions are provided to be adjacent to each other,
   the tray includes:

   a pair of projections protruding upward to be inserted into the through-holes; and
   a separating portion separating the receiving regions from each other, and
   the length L0 between the pair of through-holes, the length L1 between the pair of projections and the protrusion length L2 of the separating portion satisfy the following formula:

   $$(L2) > [(L0)/2] \times [Tan(Acos(L1)/(L0))]$$

6. The encapsulating sheet container according to Claim 4, wherein
   the separating portion is configured to be contactable with the cover in a state where the cover is superposed on the tray.

7. The encapsulating sheet container according to any one of the preceding Claims 1 to 6, wherein
   the cover includes a support portion for supporting another tray when the other tray is superposed thereon.

Fig1

UPPER
SIDE

LEFT
SIDE

REAR
SIDE

FRONT
SIDE

RIGHT
SIDE

LOWER
SIDE

1

Fig2

2

Fig3

REAR
SIDE

LEFT
SIDE

RIGHT
SIDE

FRONT
SIDE

3

Fig4

REAR
SIDE

LEFT
SIDE — RIGHT
SIDE

FRONT
SIDE

4

Fig5

UPPER
SIDE

LEFT ← → RIGHT
SIDE        SIDE

LOWER
SIDE

EP 2 725 608 A2

5

Fig6

UPPER
SIDE

LEFT
SIDE

RIGHT
SIDE

LOWER
SIDE

6

EP 2 725 608 A2

Fig7

Fig8

Fig9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009141020 A